# EUROPEAN PATENT APPLICATION

(11) **EP 4 671 920 A1**
(43) Date of publication of application: **31.12.2025**
(21) Application number: 24921472.7
(22) Date of filing: 27.09.2024
(51) Int. Cl.: G06F 1/20

(54) **LIQUID-COOLED SERVER**

(30) Priority: 31.01.2024 CN 202410136851
(71) Applicant: Suzhou Metabrain Intelligent Technology Co., Ltd., Suzhou, Jiangsu 215000 (CN)
(72) Inventor: JIAO, Naixun, Suzhou, Jiangsu 215000 (CN); LI, Jinbo, Suzhou, Jiangsu 215000 (CN); WANG, Dawei, Suzhou, Jiangsu 215000 (CN); FENG, Yunqi, Suzhou, Jiangsu 215000 (CN); GUO, Jie, Suzhou, Jiangsu 215000 (CN)
(74) Representative: Studio Torta S.p.A.
(86) International application number: PCT/CN2024/121985
(87) International publication number: WO 2025/161448

(57) **Abstract**

Disclosed is a liquid-cooled server, including a chassis and a liquid-cooling heat dissipation system. The chassis has an accommodating cavity, a main control panel, a central processing unit, a memory bank, and a graphics processing unit are arranged inside the accommodating cavity, the central processing unit, the memory bank, and the graphics processing unit are electrically connected to the main control panel; the liquid-cooling heat dissipation system is at least partially located inside the accommodating cavity, the liquid-cooling heat dissipation system includes a liquid cooling loop, a cooling liquid in the liquid cooling loop flows through a liquid cooling plate at the central processing unit, a liquid cooling assembly at the memory bank, and the graphics processing unit, and removes heat generated by the central processing unit through the liquid cooling plate and heat generated by the memory bank through the liquid cooling assembly, and removes heat generated by the graphics processing unit by flowing through the graphics processing unit. The present invention solves a problem that a liquid cooling manner for the liquid-cooled server in the related art is complex.

## Description

### Cross-Reference to Related Application

The present invention claims the priority to Chinese Patent Application No. 202410136851.2, filed with China National Intellectual Property Administration (CNIPA) on January 31, 2024 and entitled "Liquid-Cooled Server", which is herein incorporated by reference in its entirety.

### Technical Field

The present invention relates to the technical field of electronic devices, and in particular to a liquid-cooled server.

### Background

With the continuous deepening of social digital transformation, computing power has become a core force for supporting and promoting the development of digital economy, and plays an important role in promoting technological progress, social governance, and other aspects. Meanwhile, artificial intelligence technologies represented by large-scale model training are also driving artificial intelligence (AI) towards higher universality. Therefore, servers, as electronic devices that provide computing power, are also being developed towards high density and flexibility.

A traditional Al server and eight graphics processing unit (GPU) cards are integrated on the same mainboard, so that it is expensive, consumes a lot of power, and often requires a height of 4U or 6U for the entire machine. For some scenes that have a low workload and only require four or even two GPU cards, the flexibility in GPU quantity is lost, and a deployment space of an internet data center (IDC) rack is wasted. In response to this situation, peripheral component interconnect express (PCIe) version GPUs have emerged. Each GPU card has an independent structure and does not need to be integrated on the same mainboard. Each GPU card can be configured separately according to a need, and can be used with a general-purpose central processing unit (CPU) server. This satisfies the flexibility in a maximum GPU quantity and makes an entire server to be 1U or 2U. In addition, requirements for the IDC rack are not high.

In the related art, when a PCIe version GPU is used with a general-purpose CPU server, the GPU is cooled by air cooling in most cases, that is, a GPU card is cooled relying on a high-speed fan. In this case, in one aspect, significant noises can be generated, which will have a negative impact on machine room operation and maintenance personnel and a surrounding environment. In another aspect, increasing the rotating speed of the fan consumes more power. This will also increase the power usage effectiveness (PUE) of a data center and is not conducive to environmentally-friendly development of the data center towards energy conservation and consumption reduction.

At present, in some CPU servers or 8-card GPU servers, a liquid cooling technology is gradually employed. To be specific, cooling liquid is used as a heat conduction medium to bring heat out of a server through a component such as a cooling plate that in a manner of being in contact with a heating component of the server, to provide a better working temperature for a high-power heating component such as a CPU and a GPU. This can effectively improve computing efficiency and stability of the server, meet requirements of energy saving and noise reduction, and help to increase a server density of a single cabinet, thereby improving computing efficiency of the data center.

However, it is hard to apply and promote the liquid cooling manner to the PCIe version GPUs. A main reason is that the structure of each PCIe version GPU card is relatively independent, and a relative position of mounting the PCIe version GPU card in the server is not fixed. In addition, each GPU card needs to be replaced separately during operation and maintenance. These conditions determine that each PCIe version GPU card needs to be equipped with one cooling plate. Consequently, each PCIe version GPU card requires an independent liquid supply and return connector. Unlike traditional 8-card GPU server chips that are located on the same horizontal plane and have fixed relative positions, the cooling plate can be designed as a whole which requires only a pair of liquid supply and return connectors. These quick connectors added on the PCIe version GPU cards need to be in plugging fit with another ends of connectors with corresponding model numbers in order to be connected into a liquid loop. In addition, a cooling requirement of each GPU card can be met only if cooling liquid with a proper flow rate is provided.

### Summary

The present invention mainly aims to provide a liquid-cooled server, to solve a problem that a liquid cooling manner for a liquid-cooled server in the related art is complex.

To achieve the above objective, some embodiments of the present invention provide a liquid-cooled server, including a chassis and a liquid-cooling heat dissipation system. The chassis has an accommodating cavity, a main control panel, a central processing unit, a memory bank, and a graphics processing unit are arranged inside the accommodating cavity, the central processing unit, the memory bank, and the graphics processing unit are electrically connected to the main control panel; the liquid-cooling heat dissipation system is at least partially located inside the accommodating cavity, the liquid-cooling heat dissipation system includes a liquid cooling loop, a cooling liquid in the liquid cooling loop flows through a liquid cooling plate at the central processing unit, a liquid cooling assembly at the memory bank, and the graphics processing unit, and removes heat generated by the central processing unit through the liquid cooling plate and heat generated by the memory bank through the liquid cooling assembly, and removes heat generated by the graphics processing unit by flowing through the graphics processing unit.

In some embodiments, a plurality of liquid cooling plates are provided; the plurality of liquid cooling plates are sequentially connected in series end to end on the liquid cooling loop, and the plurality of liquid cooling plates exchange heat with one or more central processing units; and/or a plurality of liquid cooling assemblies are provided; the plurality of liquid cooling assemblies are sequentially connected in series end to end on the liquid cooling loop, and the plurality of liquid cooling assemblies exchange heat with one or more memory banks; and/or a plurality of graphics processing units are provided; and the plurality of graphics processing units are arranged in parallel on the liquid cooling loop.

In some embodiments, the liquid-cooling heat dissipation system further includes a conversion device, the conversion device is arranged on the liquid cooling loop and is located at a downstream of the liquid cooling assembly; the conversion device has a first flow channel and a second flow channel; the first flow channel has a main input interface and a plurality of branch output interfaces; the main input interface is communicated to an outlet of the liquid cooling assembly, and a cooling liquid in the liquid cooling assembly is collected into the first flow channel; the plurality of branch output interfaces are respectively communicated to first liquid inlets corresponding to the plurality of graphics processing units; the second flow channel has a main output interface and a plurality of branch input interfaces; the main output interface is communicated to an external cooling liquid recovery device; and the plurality of branch input interfaces are respectively communicated to first liquid outlets corresponding to the plurality of graphics processing units.

In some embodiments, the accommodating cavity has a first accommodating region and a second accommodating region; the second accommodating region is located above the first accommodating region; the central processing unit, the memory bank, and a portion of the liquid cooling loop are located in the first accommodating region; and the graphics processing unit and at least a portion of the remaining liquid cooling loop are located in the second accommodating region.

In some embodiments, the liquid-cooling heat dissipation system further includes a first leakage detection line, and the first leakage detection line is located in the first accommodating region and is laid along an extension path of the liquid cooling loop located in the first accommodating region, and is configured to detect whether the cooling liquid is leaking from the liquid cooling loop located in the first accommodating region.

In some embodiments, the liquid-cooling heat dissipation system further includes a liquid collection tray and a second leakage detection line, the liquid collection tray is located between the first accommodating region and the second accommodating region; at least the liquid collection tray receives a cooling liquid leaking from a joint between the liquid cooling loop located in the second accommodating region and the graphics processing unit; and the second leakage detection line is located inside the liquid collection tray, and is configured to detect whether the cooling liquid is received in the liquid collection tray.

In some embodiments, a bottom receiving surface of the liquid collection tray is inclined, and a portion of the bottom receiving surface corresponding to the joint is a lowest surface; and the second liquid leakage detection line is at least partially laid on the lowest surface.

In some embodiments, the first leakage detection line and the second leakage detection line are in plugging connection through a detection line male head and a detection line female head; one end, away from the second leakage detection line, of the first leakage detection line is in signal connection to a control module to transmit a detected leakage signal to the control module; or one end, away from the first leakage detection line, of the second leakage detection line is in signal connection to the control module to transmit a detected leakage signal to the control module.

In some embodiments, the liquid cooling assembly includes a liquid separation structure, a liquid collection structure, and a plurality of cooling plate sub-members; the liquid separation structure has a first flow cavity, a second liquid inlet communicated to the first flow cavity, and a plurality of first liquid separation ports; the liquid collection structure has a second flow cavity, a second liquid outlet communicated to the second flow cavity, and a plurality of second liquid separation ports; the plurality of cooling plate sub-members are sequentially arranged in parallel between the liquid separation structure and the liquid collection structure; and a quantity of the plurality of cooling plate sub-members, a quantity of the plurality of first liquid separation ports, and a quantity of the plurality of second liquid separation ports are equal, and two ends of each cooling plate sub-member are respectively communicated to one corresponding first liquid separation port and one corresponding second liquid separation port.

In some embodiments, a middle portion of each cooling plate sub-member is concave, and two ends thereof are bent.

In some embodiments, the liquid cooling assembly further includes a heat conduction plate, the heat conduction plate is arranged at the concave middle portion of each cooling plate sub-member; and a thickness of the heat conduction plate is equal to a thickness of each cooling plate sub-member.

In some embodiments, the heat conduction plate has a first avoidance notch; and the first avoidance notch is configured to avoid a chip protruding out of the memory bank.

By applying the technical solutions of the present invention, the liquid-cooled server with the liquid-cooling heat dissipation system is provided. The cooling liquid in the liquid cooling loop of the liquid-cooling heat dissipation system flows through the liquid cooling plate at the central processing unit, the liquid cooling assembly at the memory bank, and the graphics processing unit, thus removing the heat generated by the central processing unit through the liquid cooling plate and removing the heat generated by the memory bank through the liquid cooling assembly, and the cooling liquid flows through the graphics processing unit to remove the heat generated by the graphics processing unit. This ensures that temperatures of the central processing unit, the memory bank, and the graphics processing unit may be within a normal working range, thereby ensuring working reliability of the central processing unit, the memory bank, and the graphics processing unit.

In addition, by adding the liquid cooling assembly at the memory bank and the graphics processing unit into the liquid cooling loop, a proportion of liquid cooling in total power consumption of the liquid-cooled server is further increased. That is, the liquid cooling accounts for 90% or above of the total power consumption of the server, which is conductive to further reducing power usage effectiveness (PUE) of a data center. The PUE refers to an index of energy efficiency of the data center.

### Brief Description of the Drawings

The accompanying drawings of this specification forming a part of the present invention are used to provide a further understanding of the present invention, and the specific embodiments and their explanations of the present invention are used to explain the present invention and do not constitute an improper limitation on the present invention. In the accompanying drawings:
Fig. 1 shows a schematic internal diagram of a chassis of a liquid-cooled server according to an embodiment of the present invention;
Fig. 2 shows a partially schematic structural diagram of the chassis in Fig. 1;
Fig. 3 shows a schematic exploded structural diagram of the chassis in Fig. 2;
Fig. 4 shows a schematic structural diagram of Fig. 2 in which a graphics processing unit and a liquid collection tray are omitted;
Fig. 5 shows a schematic structural diagram of Fig. 4 in which a liquid cooling loop connected to the graphics processing unit and a conversion device are omitted;
Fig. 6 shows a schematic structural diagram of Fig. 5 in which the conversion device is omitted;
Fig. 7 shows a schematic diagram of a flowing direction of cooling liquid in the liquid cooling loop in Fig. 6;
Fig. 8 shows a schematic structural diagram of Fig. 2 in which a graphics processing unit is omitted;
Fig. 9 shows a partially schematic structural diagram of a conversion device in Fig. 8, in which a cover plate is in an open state;
Fig. 10 shows a schematic structural diagram of a liquid cooling assembly in Fig. 6;
Fig. 11 shows a schematic exploded structural diagram of the liquid cooling assembly in Fig. 10; and
Fig. 12 shows a schematic structural diagram of a memory bank of a liquid-cooled server according to an embodiment of the present invention.

The above accompanying drawings include the following reference numerals:
10: chassis; 11: accommodating cavity; 12: memory bank; 121: memory chip; 13: graphics processing unit; 14: liquid cooling plate; 15: liquid cooling assembly; 151: liquid separation structure; 1511: second liquid inlet; 1512: first liquid separation port; 152: liquid collection structure; 1521: second liquid outlet; 153: cooling plate sub-member; 154: heat conduction plate; 1541: first avoidance notch; 155: thermal pad; 1551: second avoidance notch;
20: liquid cooling loop; 21: liquid inlet interface; 22: liquid outlet interface;
30: conversion device; 31: first flow channel; 311: main input interface; 312: branch output interface; 32: second flow channel; 321: main output interface; 322: branch input interface; 33: cover plate;
40: first leakage detection line; 41: detection line female head; 42: end portion male head; 50: liquid collection tray; 60: second leakage detection line; 61: detection line male head; 70: bracket structure; 100: positioning hole; 200: positioning guide pin; and 300: pipeline joint.

### Detailed Description of the Embodiments

The technical solutions in embodiments of the present invention are clearly and completely described in the following with reference to the accompanying drawings in the embodiments of the present invention. Apparently, the described embodiments are merely some rather than all of the embodiments of the present invention. The following description of at least one exemplary embodiment is only for an illustrative purpose and shall not be construed as any limitation on the present invention and the application or use of the present invention. All other embodiments obtained by a person of ordinary skill in the art based on the embodiments of the present invention without making creative efforts shall fall within the protection scope of the present invention.

To solve a problem that a liquid cooling manner for a liquid-cooled server in the related art is complex, some embodiments of the present invention provide a liquid-cooled server.

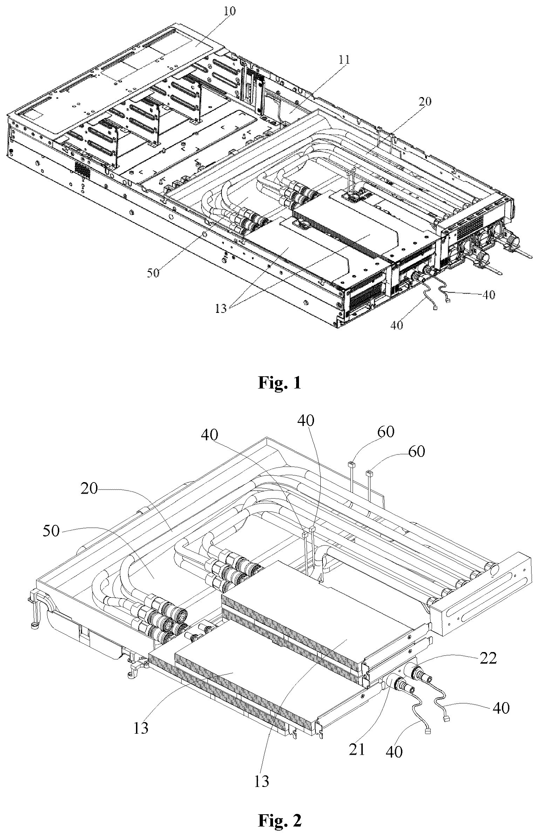

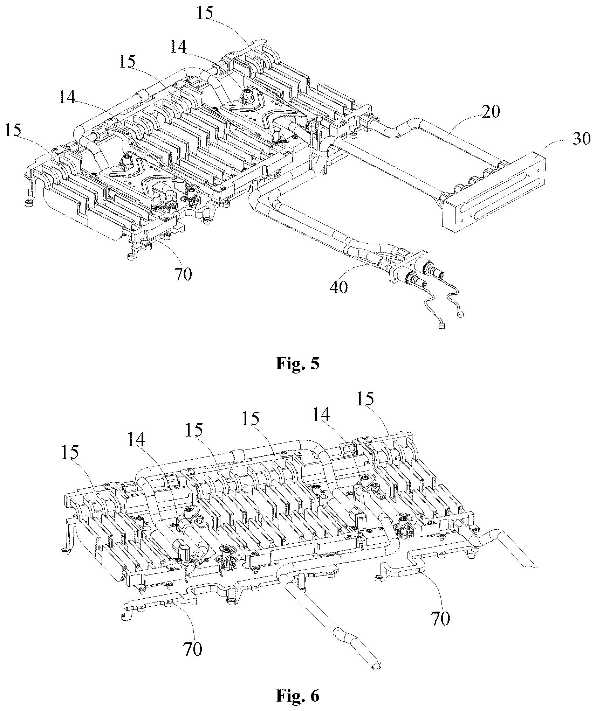

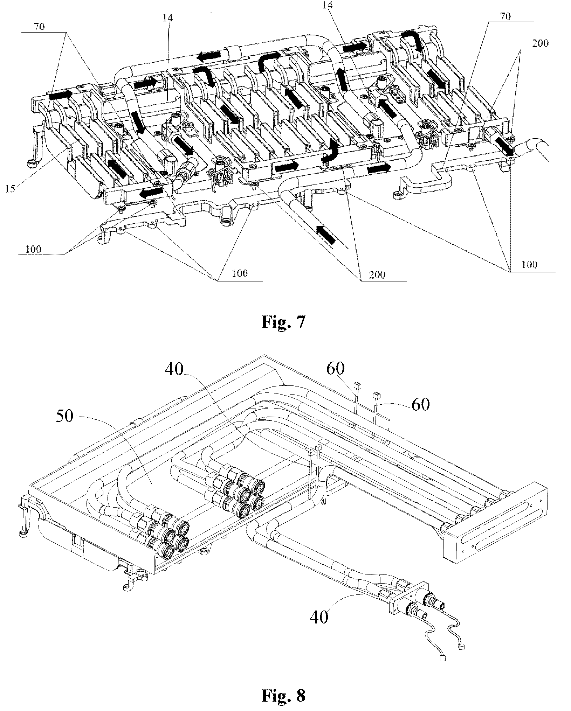

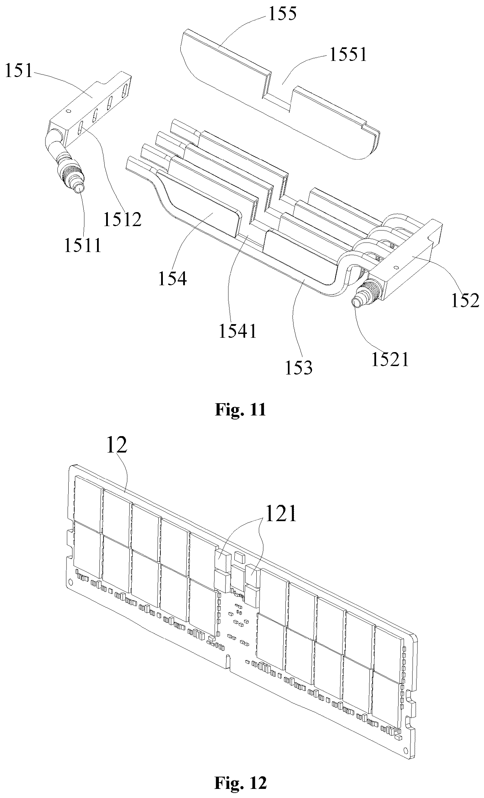

As shown in Figs. 1-12, the liquid-cooled server includes a chassis 10 and a liquid-cooling heat dissipation system 20. The chassis 10 has an accommodating cavity 11. A main control panel, a central processing unit, a memory bank 12, and a graphics processing unit 13 are arranged inside the accommodating cavity 11. The central processing unit, the memory bank 12, and the graphics processing unit 13 are electrically connected to the main control panel. The liquid-cooling heat dissipation system is at least partially located inside the accommodating cavity 11. The liquid-cooling heat dissipation system includes a liquid cooling loop 20. A cooling liquid in the liquid cooling loop 20 flows through a liquid cooling plate 14 at the central processing unit, a liquid cooling assembly 15 at the memory bank 12, and the graphics processing unit 13 to remove heat generated by the central processing unit through the liquid cooling plate 14 and heat generated by the memory bank 12 through the liquid cooling assembly 15, and flows through the graphics processing unit 13 to remove heat generated by the graphics processing unit 13.

The embodiments of the present invention provide a liquid-cooled server with a liquid-cooling heat dissipation system. The cooling liquid in the liquid cooling loop 20 of the liquid-cooling heat dissipation system flows through the liquid cooling plate 14 at the central processing unit, the liquid cooling assembly 15 at the memory bank 12, and the graphics processing unit 13, thus removing the heat generated by the central processing unit through the liquid cooling plate 14 and removing the heat generated by the memory bank 12 through the liquid cooling assembly 15, and the cooling liquid flows through the graphics processing unit 13 to remove the heat generated by the graphics processing unit 13. This ensures that temperatures of the central processing unit, the memory bank 12, and the graphics processing unit 13 may be within a normal working range, thereby ensuring working reliability of the central processing unit, the memory bank 12, and the graphics processing unit 13.

In addition, by adding the liquid cooling assembly 15 at the memory bank 12 and the graphics processing unit 13 into the liquid cooling loop 20, a proportion of liquid cooling in total power consumption of the liquid-cooled server is further increased. That is, the liquid cooling accounts for 90% or above of the total power consumption of the server, which is conductive to further reducing power usage effectiveness (PUE) of a data center. The PUE refers to an index of energy efficiency of the data center.

It should be noted that in the embodiments of the present invention, the above central processing unit refers to a CPU chip. The above graphics processing unit 13 refers to a PCIe version GPU card. The embodiments of the present invention provide a liquid-cooling heat dissipation system in which a PCIe version GPU cooperates with a general-purpose CPU server. Based on a configuration of a 2U general-purpose double-CPU server, liquid cooling on at most four PCIe version GPU cards, 32 memory banks, and two CPU chips may be supported inside.

In an embodiment, a plurality of liquid cooling plates 14 are provided. The plurality of liquid cooling plates 14 are sequentially connected in series end to end on the liquid cooling loop 20 to cause the plurality of liquid cooling plates 14 to exchange heat with one or more central processing units.

In an embodiment, a plurality of liquid cooling assemblies 15 are provided. The plurality of liquid cooling assemblies 15 are sequentially connected in series end to end on the liquid cooling loop 20 to cause the plurality of liquid cooling assemblies 15 to exchange heat with one or more memory banks 12.

In an embodiment, a plurality of graphics processing units 13 are provided. The plurality of graphics processing units 13 are arranged in parallel on the liquid cooling loop 20.

In an embodiment, as shown in Figs. 2-3, and Figs. 6-9, the liquid-cooling heat dissipation system further includes a conversion device 30. The conversion device 30 is arranged on the liquid cooling loop 20 and is located at a downstream of the liquid cooling assembly 15. The conversion device 30 has a first flow channel 31 and a second flow channel 32. The first flow channel 31 has a main input interface 311 and a plurality of branch output interfaces 312. The main input interface 311 is communicated to an outlet of the liquid cooling assembly 15, so that a cooling liquid in the liquid cooling assembly 15 is collected into the first flow channel 31. The plurality of branch output interfaces 312 are respectively communicated to first liquid inlets corresponding to the plurality of graphics processing units 13. The second flow channel 32 has a main output interface 321 and a plurality of branch input interfaces 322. The main output interface 321 is communicated to an external cooling liquid recovery device. The plurality of branch input interfaces 322 are respectively communicated to first liquid outlets corresponding to the plurality of graphics processing units 13.

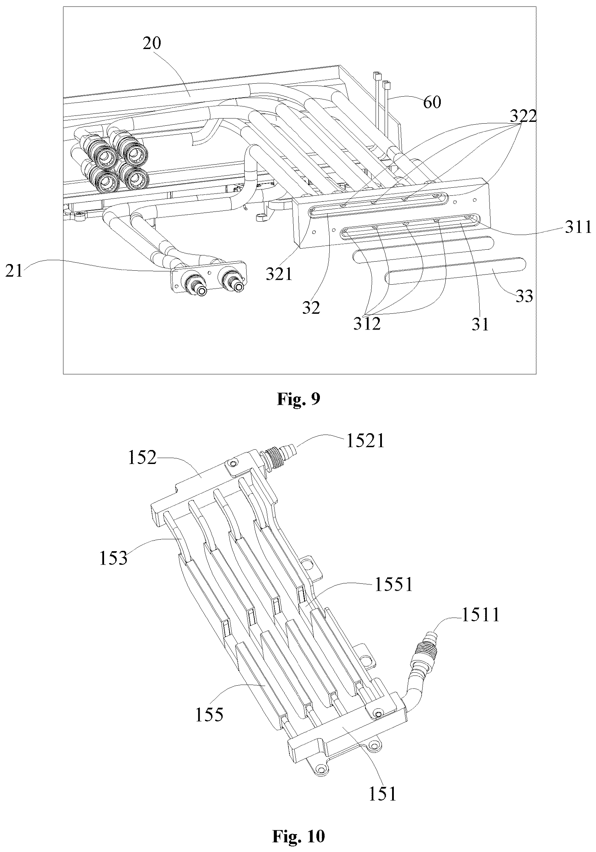

In Fig. 9, for ease of clearly observing the first flow channel 31 and the second flow channel 32, the cover plates 33 are in an open state.

Specifically, after the cooling liquid flows through four groups of liquid cooling assemblies 15 in sequence, the cooling liquid reaches the conversion device 30 through the liquid cooling loop 20. The conversion device 30 is divided into an upper layer and a lower layer, so that the cooling liquid flow is equally divided into four parts supplied to the graphics processing units 13. Then, after passing through the four graphics processing units 13, the cooling liquid is reintroduced into the conversion device 30, thus achieving parallel connection of the four graphics processing units 13. In addition, due to parallel structures between branches, the design of the conversion device 30 may support flexible configuration of two to four graphics processing units 13. That is, when the quantity of the graphics processing units 13 changes, the conversion device 30 may also uniformly divide the main flow based on a quantity of actually configured graphics processing units 13 and supply the flow to each graphics processing unit 13, without affecting other components in the liquid-cooling heat dissipation system.

It should be noted that in the embodiments of the present invention, it is considered that the cooling liquid in the liquid cooling loop 20 flows through the liquid cooling plate 14 at the central processing unit, the liquid cooling assembly 15 at the memory bank 12, and the graphics processing unit 13. Meanwhile, since the liquid-cooling heat dissipation system further includes the conversion device 30, and the conversion device 30 is arranged on the liquid cooling loop 20 and is located at the downstream of the liquid cooling assembly 15, an external cooling liquid supply source flows into the liquid cooling loop 20 through the liquid inlet interface 21. The cooling liquid in the liquid cooling loop 20 flows through the liquid cooling plate 14 at the central processing unit and the liquid cooling assembly 15 at the memory bank 12 and is then divided into four parts after being collected to the conversion device 30, so as to be supplied to the four graphic processing units 13 respectively. Afterwards, the cooling liquid is collected to the conversion device 30 from the four graphic processing units 13, flows through the main output interface 321 to the liquid outlet interface 22, and then flows through the liquid outlet interface 22 into the external cooling liquid recovery device. Here, in order to provide a clearer description subsequently, a pipeline from the liquid inlet interface 21 to the liquid cooling assembly 15 to the conversion device 30 and a pipeline from the conversion device 30 through the main output interface 321 to the liquid outlet interface 22 are used as a first portion of liquid cooling loop 20. In addition, a pipeline "in which the cooling liquid is divided into four parts at the conversion device 30, the four parts are respectively supplied to the four graphics processing units 13, and the cooling liquid inside the four graphics processing units 13 are collected to the conversion device 30 again" is used as a second portion of liquid cooling loop 20, hereinafter referred to as GPU pipeline. The GPU pipeline has a female quick connector. The female quick connector is connected to a male quick connector on each graphics processing unit 13, thus implementing circulation of the cooling liquid and removing heat of a chip on each graphics processing unit 13. Furthermore, no liquid leakage occurs in the entire process. During mounting or maintaining of the graphics processing unit 13 or when no graphics processing unit 13 is configured in a branch, namely, when the quick connector on the corresponding GPU pipeline is disconnected from the quick connector on the graphics processing unit 13, liquid sealing may also be achieved. Finally, the cooling liquid in the conversion device 30 flows through the main output interface 321 to the liquid outlet interface 22, thus forming a complete liquid loop inside the liquid-cooled server.

As shown in Figs. 1-3 and Fig. 8, the accommodating cavity 11 has a first accommodating region and a second accommodating region. The second accommodating region is located above the first accommodating region. The central processing unit, the memory bank 12, and a portion of the liquid cooling loop 20 are located in the first accommodating region; and the graphics processing unit 13 and at least a portion of the remaining liquid cooling loop 20 are located in the second accommodating region.

Specifically, in terms of spatial distribution, the liquid inlet interface 21, the liquid outlet interface 22, the liquid cooling plate 14, the liquid cooling assembly 15, and the first portion of liquid cooling loop 20 are arranged in a lower 1U space inside the liquid-cooled server. The conversion device 30, the graphics processing unit 13, the GPU pipeline (the second portion of liquid cooling loop 20), the second leakage detection line 60, and other components are arranged in an upper 1U space. This may solve a layout problem caused by the adding of the above liquid cooling components to a limited space inside the liquid-cooled server.

As shown in Figs. 2-8, the liquid inlet interface 21 and the liquid outlet interface 22 are fixed in a center of a rear window of the liquid-cooled server, and are mainly configured for connection and disconnection of a cooling liquid flow path inside the liquid-cooled server. That is, after the liquid-cooled server is mounted on a rack of a cabinet, male quick connectors, extending out of the chassis, of the liquid inlet interface 21 and the liquid outlet interface 22 may be connected to a cabinet-side manifold through quick connectors to open the liquid loop. The cooling liquid enters the liquid-cooling heat dissipation system of the liquid-cooled server from the liquid inlet interface 21, passes through two groups of liquid cooling plates 14 and four groups of liquid cooling assemblies 15 in sequence through the liquid cooling loop 20, and reaches the conversion device 30. The conversion device 30 is mounted on a right side of the rear window of the liquid-cooled server, which may uniformly divide the cooling liquid into four parts and supply the four parts to the graphics processing units 13. The four graphics processing units 13 are arranged in two columns on a left side of the rear window of the liquid-cooled server, and two graphics processing units are placed in each column. Each graphics processing unit 13 has male quick connectors at liquid supply and return ports, to achieve liquid circulation after the male quick connectors are connected to the female head on the liquid cooling loop 20. Later, the four parts of cooling liquid pass through the graphics processing units 13 and then are collected to the conversion device 30 again through the liquid cooling loop 20, thus achieving parallel connection of the four graphics processing units 13. Finally, the cooling liquid in the conversion device 30 reaches the liquid outlet interface 22 through the liquid cooling loop 20, thus forming a complete liquid loop inside the liquid-cooled server. In another aspect, the quick connectors of the graphics processing units 13 are inside the liquid-cooled server.

It should be noted that in the embodiments of the present invention, the quick connectors of the graphics processing units 13 are inside the liquid-cooled server. Therefore, in order to solve a risk caused by accidental leakage of the cooling liquid because of a fault or an abnormal situation during running and maintenance of the liquid-cooled server, as shown in Figs. 1-4 and Fig. 6, the liquid-cooling heat dissipation system further includes a first leakage detection line 40. The first leakage detection line 40 is located in the first accommodating region and is laid along an extension path of the liquid cooling loop 20 located in the first accommodating region, in order to be configured to detect whether the cooling liquid is leaking from the liquid cooling loop 20 located in the first accommodating region, the liquid cooling plate 14, and the liquid cooling assembly 15.

As shown in Figs. 1-4 and Figs. 8-9, the liquid-cooling heat dissipation system further includes a liquid collection tray 50 and a second leakage detection line 60. The liquid collection tray 50 is located between the first accommodating region and the second accommodating region. At least the liquid collection tray 50 may receive a cooling liquid leaking from a joint between the liquid cooling loop 20 located in the second accommodating region and the graphics processing unit 13. The second leakage detection line 60 is located inside the liquid collection tray 50 to detect whether the cooling liquid is received in the liquid collection tray 50.

In an embodiment, a bottom receiving surface of the liquid collection tray 50 is inclined, and a portion of the bottom receiving surface corresponding to the joint is a lowest surface; and the second liquid leakage detection line 60 is at least partially laid on the lowest surface.

It should be noted that in the embodiments of the present invention, the first leakage detection line 40 and the second leakage detection line 60 are in plugging connection through a detection line male head 61 and a detection line female head 41. One end, away from the second leakage detection line 60, of the first leakage detection line 40 is in signal connection to a control module to transmit a detected leakage signal to the control module; or one end, away from the first leakage detection line 40, of the second leakage detection line 60 is in signal connection to the control module to transmit a detected leakage signal to the control module.

In an embodiment, the first leakage detection line 40 has an end portion male head 42 that is configured to be in signal connection with the control module.

It should be noted that in the embodiments of the present invention, the above control module, i.e. a server management module, is designed with the first leakage detection line 40 and the second leakage detection line 60 for the liquid-cooling heat dissipation system of the liquid-cooled server. Once liquid leakage occurs, the first leakage detection line 40 and/or the second leakage detection line 60 may immediately detect an abnormal situation, transmit the abnormal situation to the server management module, and issue an instruction of powering off the server. This greatly improves safety of the liquid-cooled server.

Specifically, the first leakage detection line 40 is laid along the liquid loop and passes through parts with a leakage risk such as a joint between the liquid inlet interface 21 and the liquid cooling loop 20, a welded joint between the liquid cooling plate 14 and a pipeline joint 300 (one end of the pipeline joint 300 is configured to be welded with the liquid cooling plate 14 and another end of the pipeline joint 300 is configured to be connected to the liquid cooling loop 20), a direct joint between the liquid cooling plate 14 and the liquid cooling loop 20, welded joints between a liquid separation structure 151 on the liquid cooling assembly 15 and the cooling plate sub-members 153, welded joints between a liquid collection structure 152 on the liquid cooling assembly 15 and the cooling plate sub-members 153, a joint between the conversion device 30 and the liquid-cooling loop 20, and a place below the middle liquid cooling loop 20. Combination and fixing of the first leakage detection line 40 and the liquid cooling loop 20 are implemented by mounting a heat-shrinkable sleeve on an outer layer or winding an acetate tape. The second leakage detection line 60 is laid on the liquid collection tray 50 and is fixed by using a waterproof adhesive tape. The liquid collection tray 50 is arranged below the quick connector of the GPU pipeline and the graphics processing unit 13 and above the liquid cooling plate 14 and the liquid cooling assembly 15. When leakage occurs because of a fault in the quick connector in the process of connection or disconnection between the GPU pipeline and the graphics processing unit 13, leaking liquid may drop into the liquid collection tray 50, flows to the bottom under the guidance of the slope designed for the liquid collection tray 50, and reaches the region in which the second leakage detection line 60 is laid, thus triggering an alarm. This technical solution has the advantages that on the one hand, a leakage detection line laid along the GPU pipeline is canceled, so that a space inside the liquid-cooled server and the detection line costs are saved. On the other hand, unlike a manner of laying a leakage detection line along the liquid loop for the liquid cooling plate 14 and the liquid cooling assembly 15, the form of laying leakage detection line along the liquid loop for movable components such as the quick connector of the graphics processing unit 13 that needs to be connected when the GPU works and needs to be disconnected during mounting and maintenance easily causes the leakage detection line to be pulled and damaged by an external force. In addition, there are also the following problems: it is hard to fix the leakage detection line at the quick connector, the detection accuracy is low because all regions with liquid drop leakage may not be covered, and the like. Therefore, by the arrangement of the liquid collection tray for collection of the leaking liquid, the design of laying the leakage detection line on the liquid collection tray may well solve the above problems. In addition, a buckle may also be bonded to the liquid collection tray to fix the GPU pipeline.

As shown in Figs. 10-11, the liquid cooling assembly 15 includes a liquid separation structure 151, a liquid collection structure 152, and a plurality of cooling plate sub-members 153. The liquid separation structure 151 has a first flow cavity, a second liquid inlet 1511 communicated to the first flow cavity, and a plurality of first liquid separation ports 1512. The liquid collection structure 152 has a second flow cavity, a second liquid outlet 1521 communicated to the second flow cavity, and a plurality of second liquid separation ports. The plurality of cooling plate sub-members 153 are sequentially arranged in parallel between the liquid separation structure 151 and the liquid collection structure 152. A quantity of the plurality of cooling plate sub-members 153, a quantity of the plurality of first liquid separation ports 1512, and a quantity of the plurality of second liquid separation ports are equal, so that two ends of each cooling plate sub-member 153 are respectively communicated to one corresponding first liquid separation port 1512 and one corresponding second liquid separation port.

It should be noted that in the embodiments of the present invention, the liquid-cooled server includes four groups of liquid cooling assemblies 15. The four groups of liquid cooling assemblies 15 form a serially connected structure through the liquid cooling loop 20 and are locked with the chassis 10 through a bracket structure 70. The bracket structure 70 and the liquid cooling assemblies 15 are respectively designed with a positioning hole 100 and a positioning guide pin 200 to provide a positioning effect for mounting of the liquid cooling assemblies 15, to ensure assembling precision between the liquid cooling assemblies 15 and the main control panel, the memory bank 12, as well as other components.

Specifically, after the cooling liquid enters the liquid-cooled server from the liquid inlet interface 21, the cooling liquid first passes through two groups of serially connected liquid cooling plates 14 through the liquid cooling loop 20 to continuously bring away the heat generated by the work of the CPU chip to ensure that the temperature of the CPU chip is always within a normal range. Later, the cooling liquid flows into the four groups of liquid cooling assemblies 15 in sequence.

As shown in Figs. 10-11, a middle portion of each cooling plate sub-member153 is concave, and two ends of each cooling plate sub-member153 are bent.

As shown in Figs. 10-11, the liquid cooling assembly 15 further includes a heat conduction plate 154. The heat conduction plate 154 is arranged at the concave middle portion of each cooling plate sub-member 153, and a thickness of the heat conduction plate 154 is equal to a thickness of the cooling plate sub-member 153.

As shown in Figs. 10-12, the heat conduction plate 154 has a first avoidance notch 1541. The first avoidance notch 1541 is configured to avoid a memory chip 121 protruding out of the memory bank 12.

Specifically, the cooling plate sub-member 153 is formed by bending and flattening two ends of a copper pipe, and the two ends are welded with the liquid separation structure 151 and the liquid collection structure 152 to form a liquid channel, thus making the four cooling plate sub-members 153 into a parallel connected structure. Thicknesses of two heat conduction plates 154 are consistent with a thickness of the flattened copper pipe, and the two heat conduction plates 154 are respectively welded to the two ends of the cooling plate sub-members 153. Surfaces of the heat conduction plates 154 that are welded with the cooling plate sub-members 153 need to be flat and smooth to enlarge a heat conduction area of memory particles, thereby improving cooling efficiency. The bent design of the two ends of the cooling plate sub-members 153 avoids a problem of interference between the cooling plate sub-members 153 and a release latch on a memory slot, as well as the memory chip 121 protruding out of the center of the memory bank 12. Meanwhile, the first avoidance notch 1541 is formed in the region at which the two heat conduction plates 154 are disconnected. This may also avoid damage, caused by compression during plugging and unplugging, to the memory chip 121 protruding out of the center of the memory bank. A thermal pad 155 on each cooling plate sub-member 153 is integrated, which is symmetrically lapped on left and right side surfaces and a top surface of the cooling plate sub-member 153 and is bonded and fixed by back glue. The thermal pad 155 has high compressibility in a thickness direction, so that on the one hand, the thermal pad 155 is used for filling a gap between the cooling plate sub-member 153 and the memory bank 12 after mounting and satisfy dimensional tolerances of processing and assembling procedures, to ensure good contact between the memory particles and the cooling plate sub-member 153 and help improve the cooling efficiency. On the other hand, an anti-scratch film on an outer layer of the thermal pad 155 and the lapping design are conductive to avoiding deformation and damage of the thermal pads due to mounting and removal of the memory bank, thus increasing a number of times of cycle use. A second avoidance notch 1551 is provided at a position, opposite to the first avoidance notch 1541, on the thermal pad 155.

In addition, unlike arranging the quick connector on the existing cooling plate outside the chassis 10 of the server, arranging the quick connector of the PCIe version liquid cooling graphics processing unit 13 inside the chassis 10 of the server may cause a risk that liquid leaks and drops onto a mainboard. Therefore, designing a leakage detection system is very important. It is hard to implement the above added liquid cooling components within the limited space of the general-purpose CPU server.

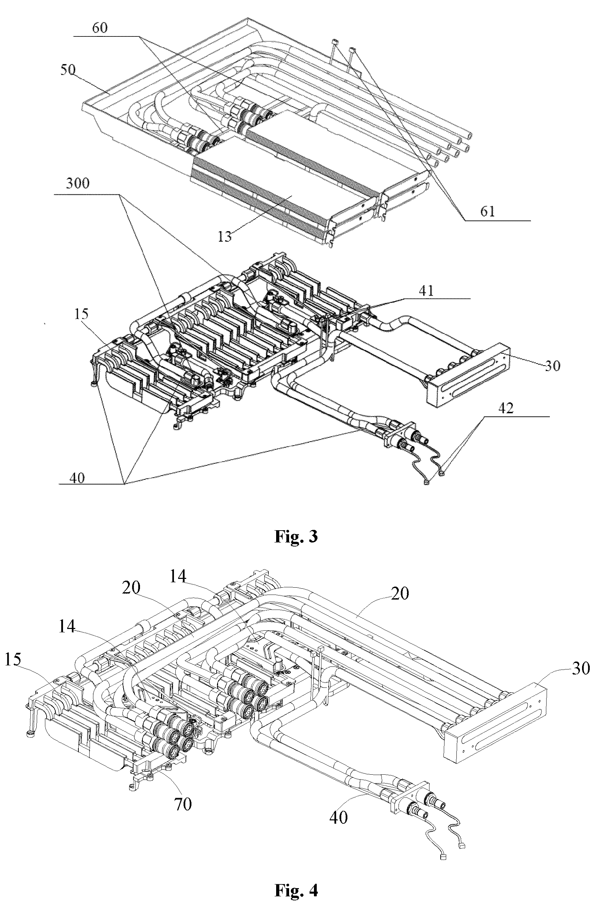

As shown in Figs. 4-6, the liquid-cooled server further includes a bracket structure 70. The bracket structure 70 is arranged in the accommodating cavity 11. The liquid cooling assembly 15 is arranged on the bracket structure 70, so that the bracket structure 70 provides a supporting effect for the liquid cooling assembly 15.
(1) Compared with the traditional general-purpose CPU liquid-cooled server, this technical solution is that the liquid cooling loop inside the 2U general-purpose CPU liquid-cooled server cools high-power devices such as two CPUs, 32 memory banks, and at most four graphics processing units 13, to ensure that temperatures of the devices are within normal ranges. Meanwhile, a total flow of the liquid-cooling heat dissipation system does not need to be additionally increased, so that the liquid cooling components cause a limited increase in a total pressure drop of the entire system, and an existing refrigeration device of the data center may be compatible. In another aspect, the liquid cooling assembly for the memory bank and the PCIe graphics processing unit 13 are added into the liquid-cooling heat dissipation system, which further increases the proportion of the liquid cooling in total power consumption of the liquid-cooled server and helps further reduce the PUE of the data center.
(2) To avoid the damage, caused by compression during plugging and unplugging, to the chip protruding out of the center of the memory bank, the avoidance design is employed for the structure of the cooling plate sub-members 153. In this technical solution, each cooling plate sub-member 153 is formed by flattening the cooper pipe. The difference is that the two ends of the cooling plate sub-member 153 are bent and are welded with a water separation bar to form the liquid channel. In addition, the thicknesses of two heat conduction plates 154 is equal to a thickness of a flattened copper pipe, and the two heat conduction plates 154 are respectively welded to the two ends of the cooling plate sub-members 153. The surfaces of the heat conduction plates 154 that are welded with the cooling plate sub-members 153 need to be flat and smooth to enlarge a heat conduction area of the memory particles, thereby improving cooling efficiency. The bent design of the two ends of the cooling plate sub-members 153 avoids the problem of interference between the cooling plate sub-members 153 and the release latch on the memory slot, as well as the chip 121 protruding out of the center of the memory bank is avoided. Meanwhile, the region at which the two heat conduction plates 154 are disconnected may also avoid the chip protruding out of the center of the memory bank, to avoid damage to the memory bank during operation.
(3) The conversion device 30 is designed in a node and includes an upper layer and a lower layer. Each layer has a flow channel, namely, the first flow channel 31 and the second flow channel 32. Each layer has five interfaces including one main interface and four branch interfaces. As shown in Fig. 2, Fig. 3, Fig. 6, and Fig. 7, the first flow channel 31 has one main input interface 311 and four branch output interfaces 312, and the second flow channel 32 has one main output interface 321 and four branch input interfaces 322. This may uniformly divide the cooling liquid flow into four parts to the graphics processing units 13. In addition, due to parallel structures between branches, the design of the conversion device 30 may support flexible configuration of two to four graphics processing units 13. That is, when the quantity of the graphics processing units 13 changes, the conversion device 30 may also uniformly divide the main flow based on a quantity of actually configured graphics processing units 13 and supply the flow to each graphics processing unit 13, without affecting other components in the liquid-cooling heat dissipation system. The GPU pipeline has the female quick connector. The female quick connector is connected to a male quick connector on each graphics processing unit 13, thus implementing circulation of the cooling liquid and removing heat of a chip on each graphics processing unit 13. Furthermore, no liquid leakage occurs in the entire process. During mounting or maintaining of the graphics processing unit 13 or when no graphics processing unit 13 is configured in a branch, namely, when the quick connector on the corresponding GPU pipeline is disconnected from the quick connector on the graphics processing unit 13, liquid sealing may also be achieved.
(4) Compared with the traditional general-purpose CPU liquid-cooled server, this server is added with the liquid cooling components such as the liquid cooling assembly for the memory bank, the PCIe graphics processing unit 13, the conversion device 30, and the GPU pipeline, so that the designed leakage detection device has a wider coverage region and has a different form. The difference is that the leakage detection line is divided into two parts which are connected through a wiring terminal and transmit a detected signal. The first leakage detection line 40 is laid along the liquid loop and passes through parts with a leakage risk such as joints between the liquid inlet interface 21, as well as the liquid outlet interface 22, and the liquid cooling loop 20, a welded joint between the liquid cooling plate 14 and a pipeline joint 300 (one end of the pipeline joint 300 is configured to be welded with the liquid cooling plate 14 and another end of the pipeline joint 300 is configured to be connected to the liquid cooling loop 20), a joint between the liquid cooling plate 14 and the liquid cooling loop 20, welded joints respectively between the liquid separation structure 151, as well as the liquid collection structure 152, and the cooling plate sub-members 153, a joint between the conversion device 30 and the liquid-cooling loop 20, and a place below the middle liquid cooling loop 20. The second leakage detection line 60 is laid on the liquid collection tray and is fixed by using a waterproof adhesive tape. The liquid collection tray is arranged below the quick connector of the GPU pipeline and the graphics processing unit 13 and above the liquid cooling plate 14 and the liquid cooling assembly 15. When leakage occurs because of a fault in the quick connector in the process of connection or disconnection between the GPU pipeline and the graphics processing unit 13, leaking liquid may drop into the liquid collection tray, flows to the bottom under the guidance of the slope designed for the liquid collection tray, and reaches the region in which the leakage detection line is laid, thus triggering an alarm. This technical solution has the advantages that on the one hand, a leakage detection line laid along the GPU pipeline is canceled, so that a space inside the liquid-cooled server and the detection line costs are saved. On the other hand, unlike a manner of laying a leakage detection line along the liquid loop for the liquid cooling plate 14 and the liquid cooling assembly 15, the form of laying leakage detection line along the liquid loop for movable components such as the quick connector of the graphics processing unit 13 that needs to be connected when the GPU works and needs to be disconnected during mounting and maintenance easily causes the leakage detection line to be pulled and damaged by an external force. In addition, there are also the following problems: it is hard to fix the leakage detection line at the quick connector, the detection accuracy is low because all regions with liquid drop leakage may not be covered, and the like. Therefore, by the arrangement of the liquid collection tray for collection of the leaking liquid, the design of laying the leakage detection line on the liquid collection tray may well solve the above problems.

It should be noted that the terms used here are only for describing specific embodiments and are not intended to limit the exemplary embodiments according to the present invention. As used here, unless otherwise explicitly stated in the context, a singular form is also intended to include a plural form. In addition, it should also be understood that when the terms "include" and/or "comprise" are used in this specification, they indicate the existence of features, steps, operations, devices, assemblies, and/or combinations thereof.

Unless otherwise specified, the relative arrangement, numerical expressions, and numerical values of components and steps described in these embodiments do not limit the scope of the present invention. Meanwhile, it should be understood that for the convenience of description, the dimensions of each component shown in the accompanying drawings are not drawn according to actual proportional relationships. The techniques, methods, and equipment known to those of ordinary skill in the art may not be discussed in detail, but in appropriate cases, the techniques, methods, and equipment should be considered as part of the authorization specification. In all the examples shown and discussed here, any specific values should be interpreted as merely exemplary, instead of being restrictive. Therefore, other examples of the exemplary embodiments may have different values. It should be noted that similar reference numerals and letters indicate similar items in the following drawings. Therefore, once a certain item is defined in one drawing, it is unnecessary to further discuss it in the subsequent drawings.

For ease of description, spatial relative terms such as "on", "above", "on an upper surface of", "at the top of", and the like can be used here to describe spatial positional relationships between a device or feature and other devices or features as shown in the figures. It should be understood that the spatial relative terms are intended to encompass different orientations of a device in use or operation other than those described in the figures. For example, if a device in the accompanying drawings is upside down, a device described as "being above other devices or structures" or "on other devices or structures" will be located as being "below other devices or structures" or "beneath other devices or structures". Therefore, the exemplary term "above" can include two orientations: "above" and "below". The device can also be located in different ways (rotated 90 degrees or in other orientations), and the spatial relative description used here is explained correspondingly.

It should be noted that the terms "first", "second", etc. in the specification and claims of the present invention and the above accompanying drawings are defined to distinguish similar objects, and do not have to be used to describe a specific order or sequence. It should be understood that such used data is interchangeable where appropriate, so that the implementations of the present invention described here can be implemented in an order other than those illustrated or described here.

The above descriptions are only specific embodiments of the present invention, and are not intended to limit the present invention. For those skilled in the art, the present invention may have various modifications and changes. Any modification, equivalent replacement, and improvement made within the spirit and scope of the present invention shall fall within the protection scope of the present invention.

## Claims

1. A liquid-cooled server, comprising:
a chassis (10), wherein the chassis (10) has an accommodating cavity (11); a main control panel, a central processing unit, a memory bank (12), and a graphics processing unit (13) are arranged inside the accommodating cavity (11); the central processing unit, the memory bank (12), and the graphics processing unit (13) are electrically connected to the main control panel;
a liquid-cooling heat dissipation system, wherein the liquid-cooling heat dissipation system is at least partially located inside the accommodating cavity (11); and the liquid-cooling heat dissipation system comprises:
a liquid cooling loop (20), wherein a cooling liquid in the liquid cooling loop (20) flows through a liquid cooling plate (14) at the central processing unit, a liquid cooling assembly (15) at the memory bank (12), and the graphics processing unit (13), and removes heat generated by the central processing unit through the liquid cooling plate (14) and heat generated by the memory bank (12) through the liquid cooling assembly (15), and removes heat generated by the graphics processing unit (13) by flowing through the graphics processing unit (13).

2. The liquid-cooled server as claimed in claim 1, wherein
a plurality of liquid cooling plates (14) are provided; the plurality of liquid cooling plates (14) are sequentially connected in series end to end on the liquid cooling loop (20), and the plurality of liquid cooling plates (14) exchange heat with one or more central processing units; and/or
a plurality of liquid cooling assemblies (15) are provided; the plurality of liquid cooling assemblies (15) are sequentially connected in series end to end on the liquid cooling loop (20), and the plurality of liquid cooling assemblies (15) exchange heat with one or more memory banks (12); and/or
a plurality of graphics processing units (13) are provided; and the plurality of graphics processing units (13) are arranged in parallel on the liquid cooling loop (20).

3. The liquid-cooled server as claimed in claim 1, wherein the liquid-cooling heat dissipation system further comprises:
a conversion device (30), wherein the conversion device (30) is arranged on the liquid cooling loop (20) and is located at a downstream of the liquid cooling assembly (15); the conversion device (30) has a first flow channel (31) and a second flow channel (32);
the first flow channel (31) has a main input interface (311) and a plurality of branch output interfaces (312); the main input interface (311) is communicated to an outlet of the liquid cooling assembly (15), and a cooling liquid in the liquid cooling assembly (15) is collected into the first flow channel (31); the plurality of branch output interfaces (312) are respectively communicated to first liquid inlets corresponding to the plurality of graphics processing units (13);
the second flow channel (32) has a main output interface (321) and a plurality of branch input interfaces (322); the main output interface (321) is communicated to an external cooling liquid recovery device; and the plurality of branch input interfaces (322) are respectively communicated to first liquid outlets corresponding to the plurality of graphics processing units (13).

4. The liquid-cooled server as claimed in claim 3, wherein the first flow channel (31) and the second flow channel (32) are spaced apart from each other vertically in a height direction of the conversion device (30).

5. The liquid-cooled server as claimed in claim 3, wherein the conversion device (30) further comprises two cover plates (33); and the two cover plates (33) are respectively covered at the first flow channel (31) and the second flow channel (32).

6. The liquid-cooled server as claimed in claim 1, wherein the accommodating cavity (11) has a first accommodating region and a second accommodating region; the second accommodating region is located above the first accommodating region; the central processing unit, the memory bank (12), and a portion of the liquid cooling loop (20) are located in the first accommodating region; and the graphics processing unit (13) and at least a portion of the remaining liquid cooling loop (20) are located in the second accommodating region.

7. The liquid-cooled server as claimed in claim 6, wherein the liquid-cooling heat dissipation system further comprises:
a first leakage detection line (40), wherein the first leakage detection line (40) is located in the first accommodating region and is laid along an extension path of the liquid cooling loop (20) located in the first accommodating region, and is configured to detect whether the cooling liquid is leaking from the liquid cooling loop (20) located in the first accommodating region.

8. The liquid-cooled server as claimed in claim 7, wherein the liquid-cooling heat dissipation system further comprises:
a liquid collection tray (50), wherein the liquid collection tray (50) is located between the first accommodating region and the second accommodating region; at least the liquid collection tray (50) receives a cooling liquid leaking from a joint between the liquid cooling loop (20) located in the second accommodating region and the graphics processing unit (13); and
a second leakage detection line (60), wherein the second leakage detection line (60) is located inside the liquid collection tray (50), and is configured to detect whether the cooling liquid is received in the liquid collection tray (50).

9. The liquid-cooled server as claimed in claim 8, wherein a bottom receiving surface of the liquid collection tray (50) is inclined, and a portion of the bottom receiving surface corresponding to the joint is a lowest surface; and the second liquid leakage detection line (60) is at least partially laid on the lowest surface.

10. The liquid-cooled server as claimed in claim 8, wherein the first leakage detection line (40) and the second leakage detection line (60) are in plugging connection through a detection line male head (61) and a detection line female head (41);
one end, away from the second leakage detection line (60), of the first leakage detection line (40) is in signal connection to a control module to transmit a detected leakage signal to the control module; or
one end, away from the first leakage detection line (40), of the second leakage detection line (60) is in signal connection to the control module to transmit a detected leakage signal to the control module.

11. The liquid-cooled server as claimed in claim 10, wherein the first leakage detection line (40) has an end portion male head (42), and the end portion male head (42) is in signal connection to the control module.

12. The liquid-cooled server as claimed in claim 8, wherein the liquid collection tray (50) is provided with a buckle; and the buckle is configured to fix at least a portion of the liquid cooling loop (20).

13. The liquid-cooled server as claimed in any one of claims 1 to 12, wherein the liquid cooling loop (20) comprises a liquid inlet interface (21) and a liquid outlet interface (22); and the cooling liquid flows into the liquid cooling loop (20) through the liquid inlet interface (21) and flows into an external cooling liquid recovery device through the liquid outlet interface (22).

14. The liquid-cooled server as claimed in any one of claims 1 to 12, wherein the liquid cooling assembly (15) comprises:
a liquid separation structure (151), wherein the liquid separation structure (151) has a first flow cavity, a second liquid inlet (1511) communicated to the first flow cavity, and a plurality of first liquid separation ports (1512);
a liquid collection structure (152), wherein the liquid collection structure (152) has a second flow cavity, a second liquid outlet (1521) communicated to the second flow cavity, and a plurality of second liquid separation ports;
a plurality of cooling plate sub-members (153), wherein the plurality of cooling plate sub-members (153) are sequentially arranged in parallel between the liquid separation structure (151) and the liquid collection structure (152); and a quantity of the plurality of cooling plate sub-members (153), a quantity of the plurality of first liquid separation ports (1512), and a quantity of the plurality of second liquid separation ports are equal, and two ends of each cooling plate sub-member (153) are respectively communicated to one corresponding first liquid separation port (1512) and one corresponding second liquid separation port.

15. The liquid-cooled server as claimed in claim 14, wherein a middle portion of each cooling plate sub-member (153) is concave, and two ends thereof are bent.

16. The liquid-cooled server as claimed in claim 15, wherein the liquid cooling assembly (15) further comprises:
a heat conduction plate (154), wherein the heat conduction plate (154) is arranged at the concave middle portion of each cooling plate sub-member (153); and a thickness of the heat conduction plate (154) is equal to a thickness of each cooling plate sub-member (153).

17. The liquid-cooled server as claimed in claim 16, wherein the heat conduction plate (154) has a first avoidance notch (1541); and the first avoidance notch (1541) is configured to avoid a chip (121) protruding out of the memory bank (12).

18. The liquid-cooled server as claimed in claim 17, wherein a thermal pad (155) is arranged on each cooling plate sub-member (153); and the thermal pad (155) has a second avoidance notch (1551) at a position opposite to the first avoidance notch (1541).

19. The liquid-cooled server as claimed in any one of claims 1 to 12, wherein the liquid-cooled server further comprises a bracket structure (70); the bracket structure (70) is arranged inside the accommodating cavity (11); and the liquid cooling assembly (15) is arranged on the bracket structure (70), and the bracket structure (70) supports the liquid cooling assembly (15).

20. The liquid-cooled server as claimed in claim 19, wherein the bracket structure (70) and the liquid cooling assembly (15) are respectively provided with a positioning hole (100) and a positioning guide pin (200) to provide a position for mounting of the liquid cooling assembly (15).
